**Europäisches Patentamt**

**European Patent Office**

**Office européen des brevets**

(11) Numéro de publication : **0 366 540 B1**

(12) **FASCICULE DE BREVET EUROPEEN**

(45) Date de publication du fascicule du brevet :
**28.12.94 Bulletin 94/52**

(51) Int. Cl.⁵ : **H04N 5/33,** H04N 5/217, H01L 27/14, H01L 29/76

(21) Numéro de dépôt : **89402929.7**

(22) Date de dépôt : **24.10.89**

(54) **Plaquette de prétraitement des courants de sortie de diodes de détection soumises à un rayonnement thermique.**

(30) Priorité : **25.10.88 FR 8813911**

(43) Date de publication de la demande :
**02.05.90 Bulletin 90/18**

(45) Mention de la délivrance du brevet :
**28.12.94 Bulletin 94/52**

(84) Etats contractants désignés :
**DE GB IT**

(56) Documents cités :
**EP-A- 0 082 616**
**EP-A- 0 148 086**
**EP-A- 0 149 948**
**EP-A- 0 230 809**

(73) Titulaire : **SAT (SOCIETE ANONYME DE TELECOMMUNICATIONS) Société Anonyme française**
**41, rue Cantagrel**
**F-75631 Paris Cédex 13 (FR)**

(72) Inventeur : **Pruvot, Henri Guy**
**86 avenue Emile Zola**
**F-75015 Paris (FR)**

(74) Mandataire : **Bloch, Gérard et al**
**2, square de l'Avenue du Bois**
**F-75116 Paris (FR)**

# Description

La présente invention tire son origine de la détection mise en oeuvre par exemple dans une caméra thermique d'analyse de paysages en temps réel, par exemple intégrée dans un système d'imagerie ou de veille.

Une caméra thermique infrarouge comprend en premier lieu, dans le plan focal de son système optique, une plaquette de détection, contenant une mosaïque de plusieurs centaines, voir d'un millier, de photodiodes infrarouge. Compte tenu du nombre important de diodes, leur liaison à un circuit de traitement externe par des moyens classiques est exclu. La plaquette de détection est donc superposée et reliée à une plaquette de prétraitement, disposée aussi, ou quasiment, dans le plan focal - les deux plaquettes sont ainsi hybridées -, la plaquette de prétraitement contenant des circuits à transfert de charges, à savoir, et essentiellement, des circuits d'entrée associés aux photodiodes pour intégrer leurs courants de sortie, des dispositifs de préamplification, de filtrage et de multiplexage et un circuit de sortie, formant également interface entre la plaquette de prétraitement et une plaquette distincte de traitement subséquent. Les liaisons des plaquettes entre elles peuvent être du type "poutre" (beam-lead).

Pour optimaliser les performances, c'est-à-dire pour minimiser les bruits parasites, la plaquette de détection doit fonctionner à basse température. L'ensemble du plan focal, constitué par les plaquettes de détection et de prétraitement, est donc disposé à l'intérieur d'une enceinte cryogénique, ou cryostat, associée à un système de refroidissement.

Pour un éclairement, ou un fond, uniforme, les quantités de charges varient d'une ligne de détecteurs à l'autre, ce qui contribue à créer le phénomène de faux contraste, ou bruit spatial fixe, et ce qui détériore la qualité des images. Ce bruit a en fait pour origine les dispersions des courants débités par les différents détecteurs en raison des variations des

- longueurs d'onde de coupure,
- courants d'obscurité,
- impédances,
- rendements quantiques et surfaces sensibles des détecteurs,
- tensions de polarisation.

Pour éviter une saturation des circuits de traitement par ce phénomène et pour que la qualité des images obtenues ne soit pas trop détériorée, il faut donc déjà une certaine dynamique par rapport au niveau de bruit, à laquelle doit s'ajouter la dynamique propre des signaux de détection, qui dépend des écarts de température considérés.

La dynamique de scène à exploiter dans les circuits de la plaquette de prétraitement est l'un des paramètres fondamentaux qui président à leur conception. Cette dynamique est définie par le rapport entre l'excursion crête à crête du signal et le bruit efficace du fond de scène.

La technologie ne permet toutefois pas d'étendre à volonté cette dynamique. Elle est forcément bornée et il en résulte, outre une limitation de l'excursion en température exploitable, un inévitable phénomène de saturation. Si, dans le domaine de l'imagerie, la saturation des circuits n'est pas trop préjudiciable, il n'en est pas de même quand on veut détecter des objets dont la température est très supérieure à celle du fond de scène. Dans la plage des températures saturantes, deux points chauds de températures respectivement différentes ne peuvent pourtant pas être différenciés.

On connaît déjà, notamment par les documents EP-A-0 082 616 et EP-A-0 149 948, une plaquette de prétraitement des courants de sortie de diodes de détection soumises à un rayonnement thermique, comprenant un étage d'entrée, d'intégration des courants de sortie des diodes, un étage de sortie, délivrant un signal lié au rayonnement incident par une fonction de transfert, et des moyens pour comprimer non linéairement la fonction de transfert de la plaquette.

La compression non linéaire de la fonction de transfert, qui rend sa courbe représentative concave vers l'axe des abscisses, celui des valeurs du rayonnement, des températures ou du courant délivré par les diodes de détection, entraîne, dans la seule portion de courbe des signaux importants, une compression de dynamique et, surtout, un déplacement vers les valeurs élevées de la plage de saturation, ce qui présente indéniablement un avantage. Les faibles signaux ne sont pas affectés, la valeur du bruit de fond intégré ne l'est pas davantage, si bien que la sensibilité thermique ne se dégrade pas.

La perte de résolution vers les points chauds, due à l'abaissement de la courbe de transfert avec la plaquette des documents ci-dessus, n'est pas préjudiciable, dès lors qu'elle suffit à détecter ces points chauds avec une précision de quelques degrés seulement.

On remarquera que la compression de la fonction de transfert se distingue de la compression par variation du temps d'intégration. Cette dernière est une compression linéaire, c'est-à-dire que le signal varie proportionnellement à la durée d'intégration alors que le bruit varie proportionnellement à la racine carrée de cette durée ; cette compression linéaire altère les signaux forts et faibles de la même manière et dégrade donc la sensibilité thermique.

La plaquette du type mentionné ci-dessus n'est toutefois pas pleinement satisfaisante. Celle du document EP-A-0 082 616, par exemple, comporte une cascade de puits qui ne permettent pas d'assurer les deux fonctions d'écrêtage, d'une part, et de dérivation-compression d'autre part, cet inconvénient apparaissant plus clairement après introduction de l'invention de la présente demande. En outre, les notions d'ébasage des charges et d'évacuation des charges ébasées en sont également totalement absentes. Quant à la plaquette du document EP-A-0 149 948, avec ses moyens de stockage supplémentaires commandés par des tensions de polarisation variables, elle présente les mêmes inconvénients que la précédente.

Un procédé d'ébasage des charges intégrées par un photo détecteur est mentionné dans le document EP-A-0 148 086.

La présente invention vise donc à perfectionner la plaquette du type mentionné ci-dessus.

A cet effet, la présente invention concerne une plaquette de ce type, caractérisée par le fait que l'étage d'entrée comprend, pour chaque diode, des moyens d'intégration du courant de sortie de la diode fournissant une quantité de charges intégrées et un moyen d'ébasage des charges intégrées, d'évacuation des charges ébasées et de dérivation des charges intégrées au-delà d'un courant de seuil d'écrêtage, et les moyens de compression qui compriment la fonction de transfert de l'étage d'entrée comprennent un moyen agencé pour, au-delà d'un courant de seuil de dérivation, inférieur au courant de seuil d'écrêtage, devenir conducteur et présenter une résistance de conduction pour ne dériver qu'une partie des charges intégrées.

Comme c'est la fonction de transfert de l'étage d'entrée de la plaquette qui est comprimée, les contraintes de dynamique sont réduites au mieux puisque la compression intervient au plus près des diodes de détection.

En outre, la fonction de dérivation de charges intégrées, dans la plaquette de l'invention, est dédoublée : au-delà du seuil de conduction du moyen de dérivation, une partie des charges intégrées est dérivée alors que le moyen d'ébasage et de dérivation dérive toutes les charges intégrées au-delà du seuil d'écrêtage.

De préférence, il est prévu une pluralité de moyens de dérivation en parallèle, agencés pour, au-delà de courants de seuil de dérivation respectivement croissants, devenir conducteurs avec des résistances de conduction respectivement décroissantes.

Alternativement, le moyen de dérivation peut être agencé pour être piloté par le courant de la sortie de la diode et présenter une résistance de conduction augmentant avec le courant de sortie de la diode.

Dans ce cas, il peut être prévu un dispositif d'autozéro pour s'affranchir des caractéristiques statiques des diodes.

Dans la forme de réalisation préférée de l'invention, la plaquette de prétraitement est disposée dans une enceinte cryogénique.

De préférence encore, l'étage d'entrée comporte pour chaque diode, un transistor FET à structure MOS, intégré sur un substrat pour l'intégration du courant de sortie de la diode et l'ébasage de charges intégrées, un transistor FET d'évacuation et d'écrêtage, dont la source est constituée par le drain du transistor d'intégration et d'ébasage et un transistor FET d'évacuation de charges intégrées.

L'invention sera mieux comprise à l'aide de la description suivante de plusieurs formes de réalisation, en référence aux dessins annexés, sur lesquels

- la figure 1 représente schématiquement, en coupe, l'étage d'entrée d'une plaquette de prétraitement de l'art antérieur;
- la figure 2 représente schématiquement, vue de dessus, une première forme de réalisation de l'étage d'entrée de la plaquette de prétraitement de l'invention ;
- la figure 3 représente la courbe comprimée de la fonction de transfert de l'étage d'entrée de la figure 2 ;
- la figure 4 représente la courbe comprimée de la fonction de transfert de l'étage d'entrée d'une deuxième forme de réalisation de la plaquette de l'invention ;
- la figure 5 représente schématiquement, vue de dessus, le transistor de dérivation à deux grilles de l'étage d'entrée d'une troisième forme de réalisation de la plaquette de l'invention;
- la figure 6 représente l'étage d'entrée d'une quatrième forme de réalisation de la plaquette de l'invention ;
- la figure 7 représente la courbe comprimée de la fonction de transfert de l'étage de la figure 6 ;
- la figure 8 représente l'étage d'entrée d'une cinquième forme de réalisation de la plaquette de l'invention, et
- la figure 9 représente le transistor de dérivation de l'étage d'entrée de la figure 8, avec un dispositif d'autozéro.

Considérons d'abord une plaquette de prétraitement de type IR-CCD, de l'art antérieur, couplant une plaquette de photodiodes de détection infrarouge à un circuit de traitement externe, les deux plaquettes de détection et de prétraitement étant disposées dans le plan focal d'un système optique et ici à l'intérieur d'une enceinte cryogénique.

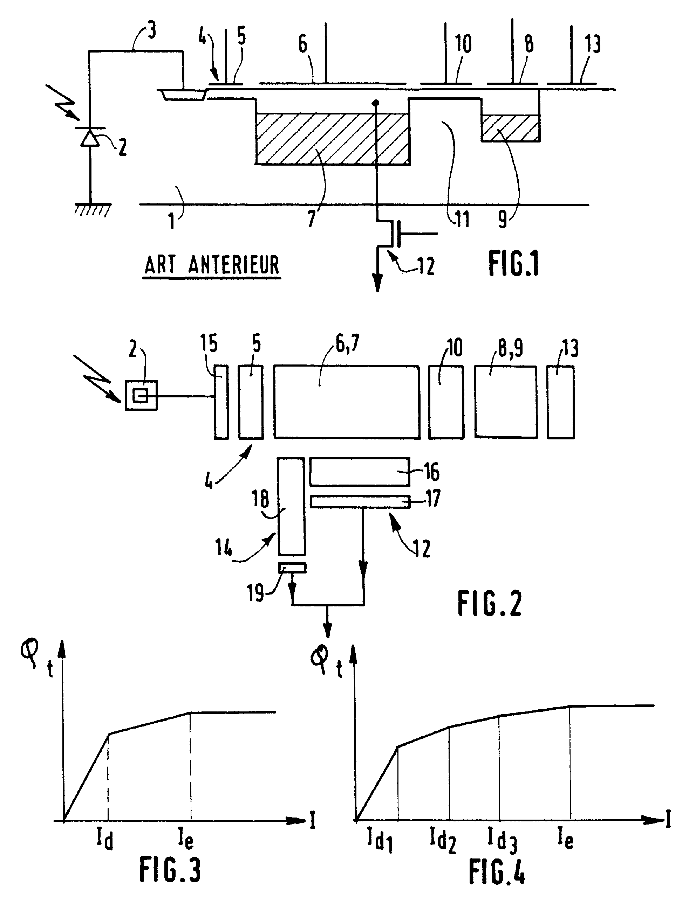

La plaquette de prétraitement comportant autant de circuits d'entrée, comme celui qui va maintenant être décrit en référence à la figure 1, qu'il y a de diodes de détection, intégrés sur un substrat 1 ici en silicium.

Soit 2 une diode infrarouge de la plaquette de détection, qui fonctionne en inverse et dont la cathode constitue la source 3 d'un transistor FET 4, à structure MOS, constituant l'étage d'entrée du circuit de prétraitement à injection directe. La grille de polarisation du transistor 4 est représentée en 5. Une plaque 6, à un potentiel de stockage, crée, dans le substrat 1, un premier puits de stockage 7 constituant le drain du transistor 4. Le drain 7 du transistor 4 constitue la source d'un deuxième transistor FET 12, dit d'évacuation et d'anti-éblouissement. De l'autre côté de la plaque de stockage 6, par rapport à la grille 5 du transistor 4, est disposée une plaque 8, à un potentiel déterminé, destinée à créer, sous elle, un deuxième puits de stockage 9. Une plaque 10, à un potentiel de transfert contrôlé par une horloge à rapport cyclique t/T variable, entre les plaques 6 et 8, au-dessus d'un espace 11 dans le substrat 1, peut permettre le transfert des charges du premier puits 7 dans le second puits 9, par création d'une charge d'espace réunissant les deux puits 7 et 9. Cette plaque 10 assure une fonction de commutateur.

Le courant de sortie de la diode 2 est donc traité dans le circuit décrit ci-dessus, qui délivre un signal de charges. Plus précisément, le courant de la diode est intégré et transformé en quantité de charges pendant la durée d'intégration t définie par l'horloge de contrôle du potentiel du commutateur 10. En d'autres termes, le photocourant de la diode 2 est intégré pendant un temps t et le circuit décrit ci-dessus effectue une conversion courant-charges, avant, à la fin de chaque période T de l'horloge de contrôle, de transférer les charges du second puits 9 dans une ligne à retard (CCD) pour traitement subséquent, par mises sous tension décalées dans le temps d'une série de grilles de transfert 13. Généralement, la durée d'intégration t est très peu inférieure à la période T.

On notera que les charges du second puits 9 pourraient aussi être directement transférées dans un convertisseur charges-tension.

Toutes les charges intégrées dans le premier puits 7, correspondant au courant délivré par la diode 2, n'ont pas à être transférées dans la ligne CCD, les autres devant être évacuées. La quantité de charges intégrées est alors ébasée, cette fonction d'ébasage étant assurée par le second puits 9 et la fonction d'évacuation par le transistor 12.

Il se peut aussi qu'il ne faille pas transférer dans la ligne CCD toutes les charges intégrées dans le premier puits 7, correspondant toujours au courant délivré par la diode 2, ces charges devant être évacuées. C'est encore le transistor 12 qui assure ce rôle dans le cadre de sa fonction d'anti-éblouissement ou de dérivation.

La méthode de la réduction du temps d'intégration t mise à part, ces fonctions d'ébasage, d'évacuation et d'anti-éblouissement vont maintenant être analysées.

### Ebasage

L'ébasage vise à ne pas transférer les charges du courant minimal de la diode qui est assimilé à celui correspondant au fond de scène moyen et donc sans signification.

L'ébasage peut être réalisé avec partition ; il peut l'être par débordement.

Une première méthode consiste, pendant la durée d'intégration t, à réunir les deux puits 7 et 9 sous l'action de la grille 10 et à intégrer le courant pour le convertir en une quantité de charges $Q_i$, avant, pendant une impulsion de partition, d'isoler ces deux puits, de transférer dans la ligne CCD la quantité $Q_t$ des charges du second puits 9 et d'évacuer, par application à la grille du transistor 12 d'un potentiel de conduction élevé, la quantité $Q_e$, dite ébasée, des charges du premier puits 7. Les quantités de charges intégrées $Q_t$, ébasée $Q_e$ et transférée $Q_t$ sont reliées par la formule

$$Q_t = \alpha(Q_i - Q_e)$$

$\alpha$ étant le coefficient de partition.

La surface de la grille 10 étant faible par rapport à celle des grilles 6 et 8, le coefficient de partition $\alpha$ dépend des surfaces $S_6$ et $S_8$ de ces grilles et est donné par la formule

$$\alpha = \frac{S_8}{S_6 + S_8}$$

Si les grilles 6 et 8 sont au même potentiel mais que leurs surfaces respectives sont différentes, c'est-à-dire si $\alpha$ est différent de 1, la limitation de la quantité de charges transférées peut être obtenue par la seule partition.

Une deuxième méthode, dite par débordement, consiste, pendant une durée d'intégration t, à intégrer le courant et à le convertir en une quantité de charges dans le premier puits 7, avant, pendant une impulsion d'ébasage et sous l'action de la grille 10, de faire déborder le premier puits 7 dans le second puits 9 puis, pendant une impulsion d'évacuation, d'évacuer les charges restantes du premier puits 7 par le transistor 12.

On notera que pendant les impulsions d'ébasage et d'évacuation, les quantités de charges intégrées dans le premier puits 7 sont négligeables.

On notera encore que, de façon générale, les charges à transférer dans la ligne CCD doivent être dans le second puits 9 avant de rendre conducteur le transistor 12.

### Anti-éblouissement

L'anti-éblouissement (anti-blooming) vise à dériver tout le courant de diode quand il est trop important et à éviter qu'un courant saturant n'altère le fonctionnement notamment de l'étage d'entrée décrit ci-dessus et des circuits de la plaquette de traitement. La fonction d'anti-éblouissement est donc assurée par le transistor 12 agissant comme un shunt d'écrêtage.

En réalité, un potentiel de conduction bas est en permanence appliqué à la grille du transistor 12. Il est insuffisant pour le rendre conducteur quand la diode 2 délivre un courant normal, mais suffisant quand il s'agit d'un courant saturant.

Dans ce cas, quand les puits 7 et 9 ne sont pas réunis, le courant est intégré dans le premier puits 7 mais les charges débordent directement dans le transistor 12 sans être transférées dans le second puits 9. Si les deux puits 7 et 9 sont réunis, ce sont les charges des deux puits réunis qui débordent encore dans le transistor 12 qui continue de jouer son rôle de dérivation.

Durant le déroulement de la fonction d'anti-éblouissement, on laisse passer les cycles d'intégration.

En résumé, tant que le courant de diode rend le transistor $T_{12}$ conducteur, avec son potentiel de grille au niveau bas, il joue son rôle d'anti-éblouissement et dérive et évacue les charges intégrées, mais non stockées dans le second puits 9, sinon, et avec son potentiel de grille au niveau haut, il joue son rôle d'évacuation des charges ébasées du premier puits 7 après intégration et stockage, dans le second puits 9, des charges à transférer.

La plaquette de prétraitement de l'invention est identique à celle qui vient d'être décrite, à l'exception du dispositif d'évacuation et de dérivation des charges intégrées.

Dans une première forme de réalisation, illustrée schématiquement en plan sur la figure 2, et les mêmes éléments étant référencés par les mêmes nombres, le dispositif d'évacuation et de dérivation comporte deux transistors FET en parallèle, le transistor 14, assurant une première partie de la fonction de dérivation, et le transistor 12, celui de la plaquette de la figure 1, assurant une deuxième partie de la fonction de dérivation et la fonction d'évacuation de la quantité de charges ébasées. La source des deux transistors 12 et 14 est constituée par le drain du transistor 4.

En 15 a été représentée la zone de diffusion d'entrée sur le substrat 1, soit la source du transistor d'entrée 4, en 16 la grille de polarisation du transistor 12, en 17 son drain, ou zone de diffusion de sortie, en 18 la grille de polarisation du transistor 14, en 19 son drain, ou zone de diffusion de sortie, reliée à la même source de polarisation que le drain 17 du transistor 12, la source des transistors 12, 14 étant constituée par le drain 7 du transistor 4.

Les géométries des deux transistors de dérivation 14 et 12, et notamment celles de leurs grilles respectivement 18, 16, sont telles que, par rapport aux dimensions du canal du transistor 12 soumis à l'action de la grille 16, le canal du transistor 14, soumis à l'action de la grille 18, a une largeur faible et une longueur grande. Ainsi, la résistance de conduction du transistor 14 est plus grande que celle du transistor 12. En d'autres termes, le potentiel de la grille 18 du transistor 14 étant toujours à un niveau bas, la résistance source-drain du transistor 14, quand le potentiel de la grille 16 du transistor 12 est au niveau haut, c'est-à-dire quand le transistor 12 "conduit" et assure sa fonction d'évacuation des charges ébasées, est beaucoup plus grande que celle du transistor 12 ; pour la fonction d'évacuation, le transistor 14 est court-circuité.

Quand le transistor 12 ne "conduit" pas, c'est-à-dire pendant l'intégration du courant de diode, la résistance du transistor 14, tout en restant élevée, est naturellement plus faible que celle, pratiquement infinie, du transistor 12. Tout comme pour le transistor 12, dont le fonctionnement a été décrit plus haut, au-delà d'un certain seuil de courant $I_d$, étant rappelé qu'un potentiel de polarisation est toujours appliqué à la grille 18, le transistor 14 est conducteur et dérive du courant. Mais comme sa résistance reste toujours relativement élevée, il n'en dérive qu'une fraction ; il n'agit pas comme le transistor 12, dont la résistance est relativement plus faible, qui, dans sa fonction de dérivation, au-delà d'un seuil de courant $I_e$, de valeur plus élevée que $I_d$, agit comme un shunt pour dériver tout le courant intégré. Le transistor 12 écrête, alors que le transistor 14 dérive, ou comprime.

La compression de dynamique obtenue avec le transistor 14 est illustrée sur la figure 3, représentant la courbe de la quantité de charges transférée $Q_t$ en fonction du courant de la diode de détection I, soit la courbe de la fonction de transfert de l'étage d'entrée de la plaquette de prétraitement. Il s'agit d'une compression à un seul palier s'étendant depuis le seuil de conduction $I_d$ du transistor de dérivation 14 jusqu'au seuil d'écrêtage ou d'anti-éblouissement du transistor 12.

Dans d'autres formes de réalisation, on peut adjoindre au précédent transistor de dérivation 14 d'autres transistors de dérivation, et en intégrer une pluralité en parallèle, avec des seuils de conduction respectifs qui augmentent et des résistances de conduction respectives qui diminuent, pour obtenir des courbes de transfert de meilleure compression, mieux incurvées, comme celle de la figure 4, à plusieurs paliers $Id_1$, $Id_2$, $Id_3$...

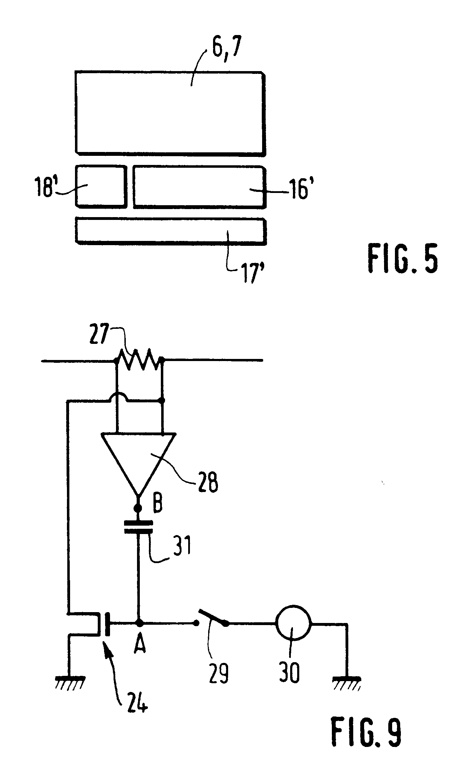

Les deux transistors 12 et 14 ont une source commune 6, 7. On pourrait également concevoir deux transistors de dérivation et de dérivation-évacuation ayant non seulement une source commune 6, 7 mais également un drain commun 17', pour former en fait un seul transistor à deux grilles 16' et 18' (figure 5). La largeur du canal soumis à l'action de la grille 18' resterait petite par rapport à celle du canal soumis à l'action de la grille 16', mais les deux canaux auraient la même longueur. Une telle solution, sans être pleinement satisfaisante pour cette raison, serait quand même intéressante au plan de la compression.

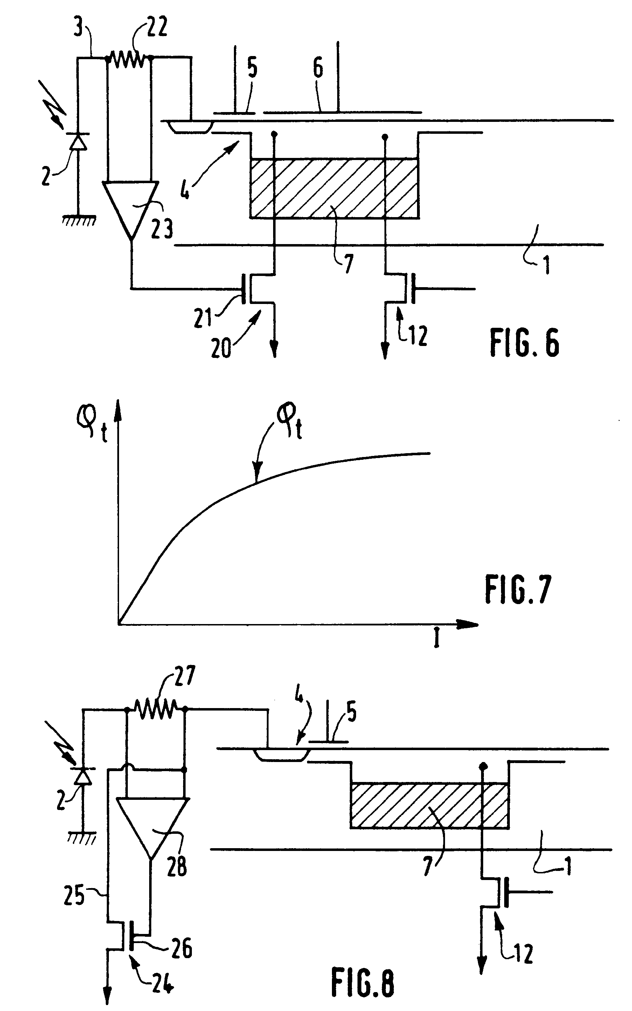

Dans une autre forme de réalisation, illustrée sur la figure 6, la fonction de dérivation est toujours dédoublée et remplie respectivement par un transistor FET 20 et le transistor 12 en parallèle, mais le transistor 20 fonctionne en résistance commandée. Sa source est constituée par le drain 7 du transistor 4 et sa grille 21 est pilotée par le courant de la diode de détection 2, saisi par une résistance 22, en série entre la cathode de la diode 2 et la source du transistor 4, et amplifié par l'amplificateur 23, aux bornes de la résistance 22, et dont la sortie est reliée à la grille 21 du transistor 20.

La valeur de la résistance drain-source du transistor 20 dépend de la tension appliquée à sa grille 21. Plus elle augmente, parce que le courant de diode augmente, plus la résistance diminue et plus l'effet de dérivation est important. On obtient ainsi directement une courbe de compression incurvée, concave vers l'axe des abscisses (figure 7).

On remarquera que la commande du transistor 20 étant asservie sur la valeur du photocourant, les faibles signaux ne sont pas affectés, et la résistance du transistor 20 diminuant exponentiellement avec la tension de grille, l'effet de compression n'en est que plus accentué pour les signaux élevés.

Dans une variante de réalisation (figure 8) de la plaquette de la figure 6, la source 25 du premier transistor de dérivation 24 est directement reliée à la source du transistor 4, mais en amont de la topographie implantée sur le substrat 1, ainsi qu'à la borne aval d'une résistance 27, en série avec la diode 2, la commande de la grille 26 du transistor 24 restant inchangée et réalisée par le photocourant mesuré par la résistance 27 et amplifié par un amplificateur 28.

L'agencement de la figure 2, au plan de la compression, est un peu moins satisfaisant que ceux des figures 6 et 8. Par contre, il offre l'avantage d'un plus haut degré d'intégration et il est donc avantageux dans le cas d'une plaquette de détection comportant de nombreuses diodes.

Les agencements des figures 6 et 8 s'appliquent tout aussi bien à des plaquettes du type IR-CCD qu'à des plaquettes d'autres types, comme par exemple les circuits CMOS associés à des détecteurs en $I_nS_b$, pour lesquels l'utilisation de ligne à retard CCD est pratiquement impossible.

Du fait des dispersions des caractéristiques statiques des diodes de détection, des fonctions de transfert des étages d'entrée non linéaires peuvent poser un petit problème, notamment dans le cas de l'agencement de la figure 2. En effet, une dispersion des points de repos, déterminés par les intersections des courbes tension-courant des diodes, d'une part, et des pseudo transistors MOS 4, qui polarisent respectivement ces diodes, d'autre part, oblige à affecter aux transistors de dérivation 14 des seuils de déclenchement différents.

Dans le cas des agencements des figures 6 et 8, il est beaucoup plus facile d'adjoindre à l'amplificateur 23, 28 de mesure du photocourant un dispositif d'autozéro (clamping).

En référence à la figure 9, qui illustre la modification apportée à l'agencement de la figure 8, mais la modification à apporter à celui de la figure 6 serait équivalente, le dispositif d'autozéro comporte un condensateur 31 connecté, d'une part, à la sortie de l'amplificateur 28 et, d'autre part, à la base du transistor 24 et à l'une des bornes d'un interrupteur 29, dont l'autre borne est reliée à un générateur 30 de tension de référence $V_{ref}$, commun à tous les dispositifs d'autozéro de tous les étages d'entrée.

Pendant chaque retour de balayage, on montre à toutes les diodes un fond uniforme de référence, à température déterminée. Pendant ces retours de balayage, l'interrupteur 29 est fermé, ce qui fixe le potentiel $V_A$ du point A, entre la base du transistor 24 et le condensateur 31, à $V_{ref}$. Pendant ces retours de balayage, la différence de potentiel $V_A - V_B$ aux bornes du condensateur 31, $V_f$ étant la tension à la sortie B de l'amplificateur 28 et qui dépend des caractéristiques statiques de la diode considérée, s'élève à

$$V_A - V_B = V_{ref} - V_f$$

A la suite du balayage d'une ligne de l'image à analyser, pendant lequel l'interrupteur 29 est ouvert, le potentiel $V_B'$ de la borne B du condensateur 31 reliée à l'amplificateur 28 étant $V_f + \Delta V$, le potentiel $V'_A$ de la borne A du condensateur 31 et dont de la grille du transistor 24 devient

$$V_A'e = (V_A - V_B) + V_B' = V_{ref} - V_f + V_f + V_f + \Delta V$$
$$= V_{ref} + \Delta V$$

Ainsi, le condensateur 31, pendant la phase du retour de balayage, a mémorisé la valeur du courant correspondant au fond de référence et, pendant la phase de balayage, ce n'est plus la valeur total du courant qui est prise en compte mais l'excursion de courant par rapport à celui du point de repos. On s'est donc affranchi des caractéristiques statiques des diodes qui affectent les niveaux de référence.

Enfin, on notera qu'un dispositif non linéaire intégré dans le plan focal permet d'utiliser une chaîne de codage de moindre dynamique, donc de mise en oeuvre plus facile, moins coûteuse et de plus faible dissipation.

## Revendications

1. Plaquette de prétraitement des courants de sortie de diodes (2) de détection soumises à un rayonnement thermique, comprenant un étage d'entrée, d'intégration des courants de sortie des diodes (2), un étage de sortie, délivrant un signal lié au rayonnement incident par une fonction de transfert et des moyens de compression (14;20;24) pour comprimer non linéairement la fonction de transfert, plaquette caractérisée par le fait que l'étage d'entrée comprend, pour chaque diode (2), des moyens (4) d'intégration du courant de sortie de la diode (2) fournissant une quantité de charges intégrées et un moyen (6-12) d'ébasage des charges intégrées, d'évacuation des charges ébasées et de dérivation des charges intégrées au-delà d'un courant de seuil d'écrêtage, et les moyens de compression, qui compriment la fonction de transfert de l'étage d'entrée, comprennent un moyen (14;20;24) agencé pour, au-delà d'un courant de seuil de dérivation, inférieur au courant de seuil d'écrêtage, devenir conducteur et présenter une résistance de conduction pour ne dériver qu'une partie des charges intégrées.

2. Plaquette selon la revendication 1, dans laquelle est prévue une pluralité de moyens de dérivation (14) en parallèle agencés pour, au-delà de courants de seuil de dérivation respectivement croissants, devenir conducteurs avec des résistances de conduction respectivement décroissantes.

3. Plaquette selon la revendication 1, dans laquelle le moyen de dérivation (20;24) est agencé pour être piloté par le courant de sortie de la diode (2) et présenter une résistance de conduction augmentant avec le courant de sortie de la diode.

4. Plaquette selon la revendication 3, dans laquelle est prévu un dispositif d'autozéro (29-31) pour s'affranchir des caractéristiques statiques des diodes (2).

5. Plaquette selon l'une des revendications 1 à 4, caractérisée par le fait qu'elle est disposée dans une enceinte cryogénique.

6. Plaquette selon la revendication 1, dans laquelle l'étage d'entrée comporte, pour chaque diode (2), un transistor FET à structure MOS (4) intégré sur un substrat (1) pour l'intégration du courant de sortie de la diode et l'ébasage de charges intégrées, un transistor FET (12) d'évacuation et d'écrêtage, dont la source est constituée par le drain (7) du transistor d'intégration et d'ébasage (4) et un transistor FET (14;20;24) d'évacuation de charges intégrées.

7. Plaquette selon la revendication 6, dans laquelle le transistor de dérivation (14) est intégré sur le substrat (1), sa source est constituée par le drain (7) du transistor d'intégration et d'ébasage (4) et le canal (18;18′) soumis à l'action de sa grille a une largeur plus petite que le canal (16;16′) soumis à l'action de la grille du transistor d'évacuation et d'écrêtage (12) pour présenter une résistance de conduction plus grande que celle du transistor d'évacuation et d'écrêtage (12).

8. Plaquette selon la revendication 7, dans laquelle les canaux (18′,16′) soumis respectivement aux grilles du transistor de dérivation et du transistor d'évacuation et d'écrêtage (12) ont la même longueur, les transistors de dérivation et d'évacuation et d'écrêtage ayant le même drain (17′) pour former un seul transistor à deux grilles (18′,16′).

9. Plaquette selon l'une des revendications 7 et 8, dans laquelle une pluralité de transistors de dérivation sont intégrés en parallèle, avec des seuils de conduction respectifs qui augmentent et des résistances de conduction respectives qui diminuent.

10. Plaquette selon la revendication 6, dans laquelle une résistance (22;27), en série entre la diode (2) et le transistor d'intégration (4), pilote, par l'intermédiaire d'un amplificateur (23;28), la grille (21;26) d'un transistor de dérivation (20;24) fonctionnant en résistance commandée.

11. Plaquette selon la revendication 10, dans laquelle la source du transistor de dérivation (20) est constituée par le drain (7) du transistor d'intégration (4).

12. Plaquette selon la revendication 10, dans laquelle la source du transistor de dérivation (20) est reliée directement à la source du transistor d'intégration, en amont de la topographie implantée sur le substrat (1).

13. Plaquette selon l'une des revendications 11 et 12, dans laquelle un condensateur (31) est connecté entre, d'une part, la sortie de l'amplificateur (28) et, d'autre part, la grille du transistor de dérivation (24) et un interrupteur (29) connecté à un générateur de tension de référence (30).

**Patentansprüche**

1. Schaltungsplatte zur Vorbehandlung der Ausgangsströme von einer thermischen Strahlung ausgesetzten Gleichrichterdioden (2), mit einer Eingangsstufe zur Integration der Ausgangsströme der Dioden (2), einer Ausgangsstufe, die ein mit der einfallenden Strahlung über eine Übertragungsfunktion verknüpftes Signal abgibt, und Mitteln (14; 20; 24) zur nichtlinearen Kompression der Übertragungsfunktion, dadurch gekennzeichnet, daß die Eingangsstufe für jede Diode (2) Mittel (4) zur Integration des Ausgangsstromes der Diode (2) aufweist, welche eine integrierte Ladungsmenge liefern, und ein Mittel (6-12) zum Abschöpfen der integrierten Ladungen, zur Abführung der abgeschöpften Ladungen und zur Ableitung der über einen Spitzenwertbegrenzungs-Schwellenstrom hinaus integrierten Ladungen, und, daß die Mittel zur Kompression, welche die Übertragungsfunktion der Eingangsstufe komprimieren, ein Mittel (14; 20; 24) aufweisen, das so ausgebildet ist, daß es oberhalb eines Ableitungsschwellenstroms unterhalb des Spitzenwertbegrenzungs-Schwellenstroms zum Leiter wird und einen Leitungswiderstand zur Ableitung nur eines Teils der integrierten Ladungen darstellt.

2. Schaltungsplatte nach Anspruch 1, bei welcher eine Vielzahl von zueinander parallelen Ableitungsmitteln (14) vorgesehen ist, die so ausgebildet sind, daß sie oberhalb der jeweils ansteigenden Ableitungsschwellenströme zu Leitern mit jeweils abnehmenden Leitungswiderständen werden.

3. Schaltungsplatte nach Anspruch 1, bei welcher das Ableitungsmittel (20; 24) so ausgebildet ist, daß es von dem Ausgangsstrom der Diode (2) gesteuert wird und einen mit dem Ausgangsstrom der Diode ansteigenden Leitungswiderstand darstellt.

4. Schaltungsplatte nach Anspruch 3, bei welcher eine Vorrichtung zur selbsttätigen Nulleinstellung (29 - 31) vorgesehen ist, um von den statischen Kennlinien der Dioden (2) frei zu werden.

5. Schaltungsplatte nach einem der Ansprüche 1 bis 4, dadurch gekennzeichnet, daß sie in einem kryogenischen Behälter angeordnet ist.

6. Schaltungsplatte nach Anspruch 1, bei welcher die Eingangsstufe für jede Diode (2) einen FET-Transistor (4) im MOS-Struktur aufweist, der in ein Substrat (1) integriert ist, zur Integration des Ausgangsstroms der Diode und zur Abschöpfung der integrierten Ladungen sowie einen FET-Transistor (12) zur Abführung und Spitzenbegrenzung, dessen Source-Elektrode durch die Drain-Elektrode (7) des Transistors (4) zur integration und zur Abschöpfung gebildet ist, und einen FET-Transistor (14; 20; 24) zur Abführung der integrierten Ladungen.

7. Schaltungsplatte nach Anspruch 6, bei welcher der Transistor (14) zur Ableitung in das Substrat (1) integriert ist, wobei seine Source-Elektrode durch die Drain-Elektrode (7) des Transistors (4) zur Integration und Abschöpfung gebildet ist, und der der Einwirkung seiner Gitterelektrode unterworfene Kanal (18; 18') eine kleinere Breite aufweist als der der Einwirkung der Gitterelektrode des Transistors (12) zur Abführung und Spitzenbegrenzung unterworfene Kanal (16; 16'), damit er einen Leitungswiderstand darstellt, der größer ist als der des Transistors (12) zur Abführung und Spitzenbegrenzung.

8. Schaltungsplatte nach Anspruch 7, bei welcher die Kanäle (18', 16'), die jeweils den Gitterelektroden des Transistors zur Ableitung und des Transistors (12) zur Abführung und Spitzenbegrenzung ausgesetzt sind, die gleiche Länge besitzen und die Transistoren zur Ableitung sowie zur Abführung und Spitzenbegrenzung dieselben Drain-Elektroden (17') besitzen zur Bildung eines einzigen Transistors mit zwei Gitterelektroden (18', 16').

9. Schaltungsplatte nach einem der Ansprüche 7 und 8, bei welcher eine Vielzahl von Transistoren zur Ableitung parallel zueinander integriert sind, die jeweils ansteigende Leitungsschwellwerte und absinkende Leitungswiderstände aufweisen.

10. Schaltungsplatte nach Anspruch 6, bei welcher ein Widerstand (22; 27), der in Serie zwischen der Diode (2) und dem Transistor (4) zur Integration angeordnet ist, unter Zwischenschaltung eines Verstärkes (23; 28), die Gitterelektrode (21; 26) eines als gesteuerter Widerstand arbeitenden Transistors (20; 24) zur Ableitung ansteuert.

11. Schaltungsplatte nach Anspruch 10, bei welcher die Source-Elektrode des Transistors (20) zur Ableitung durch die Drain-Elektrode (7) des Transistors (4) zur Integration gebildet ist.

12. Schaltungsplatte nach Anspruch 10, bei welcher die Source-Elektrode des Transistors (20) zur Ableitung direkt mit der Source-Elektrode des Transistors zur Integration oberhalb der in das Substrat (1) implantierten Topographie verbunden ist.

13. Schaltungsplatte nach einem der Ansprüche 11 und 12, bei welcher ein Kondensator (31) einerseits an den Ausgang des Verstärkers (28) und andererseits an die Gitterelektrode des Transistors (24) zur Ableitung und ein Schalter (29) an einen Generator (30) zur Erzeugung einer Referenzspannung angeschlossen ist.

**Claims**

1. A board for pretreating the output currents of detection diodes (2) exposed to thermal radiation, comprising an input stage for integration of the output currents of the diodes (2), an output stage supplying a signal, linked to the impinging radiation, by a transfer function, and compression means (14; 20; 24) to compress the transfer function in a non-linear manner, the board being characterised in that for each diode (2), the input stage comprises means (4) for integration of the output current of the diode (2) supplying a quantity of integrated charges and means (6-12) for skimming the integrated charges, evacuation of the skimmed charges and shunting of the integrated charges beyond a peak-limiting threshold current, and the compression means, which compress the transfer function of the input stage, comprise means (14; 20; 24) arranged in order, beyond a threshold shunting current lower than the peak-limiting threshold current, to become conductive and to have a resistance to conduction in order to shunt only a part of the integrated charges.

2. A board according to claim 1, in which a plurality of parallel shunt means (14) are provided, arranged to become, beyond respectively increasing shunt threshold currents, conductive having respectively decreasing conduction resistances.

3. A board according to claim 1, in which the shunt means (20; 24) is arranged to be controlled by the output current of the diode (2) and to have a conduction resistance increasing with the output current of the diode.

4. A board according to claim 3, in which an auto-zero device (29-31) is provided to free itself of the static characteristics of the diodes (2).

5. A board according to one of claims 1 to 4, characterised in that it is disposed in a cryogenic container.

6. A board according to claim 1, in which, for each diode (2), the input stage comprises a field-effect transistor (4) of MOS structure integrated on a substrate (1) for the integration of the output current of the diode and the skimming of integrated charges, an evacuation and peak-limiting field-effect transistor (12) of which the source is comprised of the drain (7) of the skimming and integration transistor (4) and a field-effect transistor (14; 20; 24) for evacuation of integrated charges.

7. A board according to claim 6, in which the shunt transistor (14) is integrated on the substrate (1), its source is comprised of the drain (7) of the integration and skimming transistor (4), and the channel (18; 18), exposed to the action of its gate electrode, is narrower than the channel (16; 16) exposed to the action of the gate electrode of the evacuation and peak-limiting transistor (12) in order to provide a conduction resistance which is greater than that of the evacuation and peak limiting transistor (12).

8. A board according to claim 7, in which the channels (18', 16') respectively exposed to the gate electrodes of the shunt transistor and the evacuation and peak-limiting transistor (12) are of the same length, the shunting and evacuation and peak-limiting transistors having the same drain (17') in order to form a single transistor with two gate electrodes (18', 16').

9. A board according to any of claims 7 and 8, in which a plurality of shunt transistors are integrated in parallel, with respective conduction thresholds which increase and respective conduction resistances which decrease.

10. A board according to claim 6, in which a resistor (22; 27) in series between the diode (2) and the integration transistor (4), controls, with the aid of an amplifier (23; 28), the gate electrode (21; 26) of a shunt transistor (20; 24) functioning with controlled resistance.

11. A board according to claim 10, in which the source of the shunt transistor (20) is comprised of the drain (7) of the integration transistor (4).

12. A board according to claim 10, in which the source of the shunt transistor (20) is connected directly to the integration transistor source upstream of the topography implanted on the substrate (1).

13. A board according to one of claims 11 and 12 in which a capacitor (31) is connected between, on the one hand, the output of the amplifier (28) and, on the other hand, the gate electrode of the shunt transistor (24) and a circuit breaker (29) connected to a reference voltage generator (30).

ART ANTERIEUR   FIG.1

FIG.2

FIG.3

FIG.4

FIG. 5

FIG. 9

**FIG. 6**

**FIG.7**

**FIG.8**